# FASCICULE DE BREVET EUROPEEN

(11) **EP 3 593 157 B1**
(45) Date de publication et mention de la délivrance du brevet: **30.07.2025**
(21) Numéro de dépôt: 18712108.2
(22) Date de dépôt: 08.03.2018
(51) Int. Cl.: G01R 33/34, G01R 33/30, G01R 33/36, G01R 33/28

(54) **CELLULE DE MESURE PAR RESONANCE MAGNETIQUE NUCLEAIRE EN MILIEU LIQUIDE AVEC UNE BOBINE À COUPLAGE INDUCTIF, SYSTEME COMPRENANT UNE TELLE CELLULE ET SON UTILISATION**
ZELLE FÜR KERNSPINRESONANZMESSUNG IN EINEM FLÜSSIGEN MEDIUM MIT EINER SPULE MIT INDUKTIVER KOPPLUNG, SYSTEM MIT SOLCH EINER ZELLE UND VERWENDUNG DAVON
CELL FOR NUCLEAR MAGNETIC RESONANCE MEASUREMENT IN A LIQUID MEDIUM, HAVING A COIL WITH INDUCTIVE COUPLING, SYSTEM COMPRISING SUCH A CELL AND THE USE THEREOF

(30) Priorité: 08.03.2017 FR 1751895
(43) Date de publication de la demande: 15.01.2020
(73) Titulaire: Commissariat à l'Energie Atomique et aux Energies Alternatives, 75015 Paris (FR)
(72) Inventeur: CARRET, Guillaume, 91400 Orsay (FR); BERTHELOT, Thomas, 91940 Les Ulis (FR); BERTHAULT, Patrick, 78114 Magny Les Hameaux (FR)
(74) Mandataire: Atout PI Laplace
(86) Numéro de dépôt international: PCT/EP2018/055794
(87) Numéro de publication internationale: WO 2018/162652

(56) Documents cités:
- FR-A1- 3 030 770
- US-A1- 2011 025 326
- GUILLAUME CARRET ET AL: "Enhancing NMR of Nonrelaxing Species Using a Controlled Flow Motion and a Miniaturized Circuit", ANALYTICAL CHEMISTRY, vol. 89, no. 5, 7 March 2017 (2017-03-07), US, pages 2995 - 3000, XP055423200, ISSN: 0003-2700, DOI: 10.1021/acs.analchem.6b04488
- JOEL A. TANG ET AL: "Practical aspects of liquid-state NMR with inductively coupled solenoid coils", MAGNETIC RESONANCE IN CHEMISTRY., vol. 48, no. 10, 1 October 2010 (2010-10-01), GB, pages 763 - 770, XP055423151, ISSN: 0749-1581, DOI: 10.1002/mrc.2651
- WEBB A G ED - KAY LEWIS ET AL: "Radiofrequency microcoils for magnetic resonance imaging and spectroscopy", JOURNAL OF MAGNETIC RESONANCE, ACADEMIC PRESS, ORLANDO, FL, US, vol. 229, 26 October 2012 (2012-10-26), pages 55 - 66, XP028996793, ISSN: 1090-7807, DOI: 10.1016/J.JMR.2012.10.004
- DAVID A. FOLEY ET AL: "NMR Flow Tube for Online NMR Reaction Monitoring", ANALYTICAL CHEMISTRY, vol. 86, no. 24, 16 December 2014 (2014-12-16), US, pages 12008 - 12013, XP055424883, ISSN: 0003-2700, DOI: 10.1021/ac502300q
- MARSDEN BRIAN ET AL: "Improving the Mass-Limited Performance of Routine NMR Probes using Coupled Coils", JOURNAL OF MAGNETIC RESONANCE, ACADEMIC PRESS, ORLANDO, FL, US, vol. 268, 20 April 2016 (2016-04-20), pages 25 - 35, XP029559266, ISSN: 1090-7807, DOI: 10.1016/J.JMR.2016.03.007

## Description

L'invention porte sur une cellule de mesure par résonance magnétique nucléaire (RMN), sur un système comprenant une telle cellule et sur un procédé de mesure par RMN utilisant une telle cellule et un tel système. Elle relève des domaines de la spectroscopie et de la micro-imagerie par résonance magnétique nucléaire en milieu liquide. Ses applications comprennent, entre autres, les techniques de RMN par transfert d'aimantation, l'étude du déroulement de réactions chimiques ou biochimiques et la biologie (étude de cellules vivantes).

La RMN est une technique qui met en jeu de très faibles énergies et fonctionne donc par accumulation de plusieurs acquisitions, afin d'augmenter le rapport signal à bruit. De manière conventionnelle, entre deux mesures successives effectuées sur un même échantillon, il est nécessaire d'attendre la relaxation longitudinale des spins nucléaires excités. Or, pour certaines espèces nucléaires, le temps de relaxation longitudinale (traditionnellement désigné par « T1 ») peut être très long - de quelques dizaines de secondes à plusieurs minutes. L'accumulation d'un grand nombre de mesures peut donc nécessiter un temps très important. Dans certains cas il est possible de contourner cette difficulté en procédant à un transfert d'aimantation vers un noyau présentant un temps de relaxation plus faible. Cette approche ne peut cependant pas être généralisée.

Dans le cas d'un échantillon fluide, une possible solution au problème du temps de relaxation longitudinale consiste à provoquer un écoulement de l'échantillon à travers une chambre de mesure contenant, à chaque instant, une petite portion du volume total du fluide. Ainsi, ce sont des noyaux différents qui font l'objet des différentes mesures à accumuler ; le temps de relaxation ne vient donc plus limiter la cadence d'acquisition. Se pose cependant le problème de produire un tel écoulement de fluide à l'intérieur d'un appareil de RMN.

Le document FR 3 030 770 et l'article de G. Carret, T. Berthelot et P. Berthault « Enhancing NMR of Nonrelaxing Species Using a Controlled Flow Motion and a Miniaturized Circuit », Analytical Chemistry 2017, 89 (5), pp 2995-3000, divulguent une cellule de mesure permettant de résoudre ce problème. Cette cellule de mesure comprend un réservoir pour un échantillon liquide, une chambre de mesure entourée par une micro-bobine à radiofréquence (RF) et des canalisations formant un circuit fluidique reliant le réservoir à la chambre de mesure. Une canalisation additionnelle permet d'injecter un gaz à l'intérieur du circuit fluidique, à une certaine distance de la chambre de mesure. Plus précisément, la chambre de mesure est agencée dans une partie basse de la cellule, le réservoir dans une partie haute et l'injection de gaz s'effectue dans une section sensiblement verticale du circuit. Le gaz injecté forme des bulles qui remontent vers le réservoir, d'où le gaz s'échappe ; cela induit un écoulement du liquide dans le sens du déplacement des bulles (principe dit de la « micro-pompe à bulles »). Il est important que les bulles ne pénètrent pas dans la chambre de mesure, car cela nuirait à l'homogénéité des champs électromagnétiques. La micro-bobine à radiofréquence est connectée électriquement à la place d'une bobine « conventionnelle » d'une sonde RMN afin d'exciter les spins nucléaires à l'intérieur de la chambre de mesure et de détecter leur réponse, qui constitue le signal RMN.

En plus de permettre la mise en mouvement du liquide, l'injection de gaz peut servir également à d'autres fins :
- Il peut s'agir d'un gaz hyperpolarisé (par exemple Xénon ou Hélium 3) afin de réaliser un transfert d'aimantation et augmenter ainsi le niveau de signal.
- Il peut apporter de l'oxygène, par exemple pour maintenir en vie des cellules en suspension dans le liquide, ou d'autres additifs.
- Il peut constituer le fluide à étudier, auquel cas la présence de liquide n'est pas essentielle.

Par ailleurs, le conduit d'injection du gaz peut également être utilisé pour introduire des liquides ou des poudres. Une application particulièrement intéressante consiste à utiliser ce conduit pour introduire un réactif réagissant avec le liquide déjà présent dans la cellule ; l'introduction de gaz met en mouvement le mélange et l'homogénéise (si plusieurs conduits d'introduction de fluide sont disponibles, il est préférable de commencer l'injection de gaz, et donc la mise en mouvement du liquide, avant l'introduction du réactif). De cette façon, il est possible d'effectuer un suivi par RMN du déroulement d'une réaction chimique ou biochimique (par exemple enzymatique). Il est important de noter que la réaction démarre à l'intérieur du spectromètre RMN, ce qui permet d'étudier ses premiers instants. Par contre, dans un système conventionnel, les réactifs sont mélangés dans le tube RMN avant son introduction dans le spectromètre ; on ne peut donc pas suivre le démarrage de la réaction.

La cellule de mesure de l'art antérieur a une structure simple et peut être fabriquée de manière additive (« impression 3D »). Cependant, elle présente deux inconvénients majeurs :
- Premièrement, pour pouvoir être alimentée par un signal à radiofréquence, la micro-bobine doit présenter une connectique spécifique, compatible avec celle d'une sonde RMN du commerce à laquelle la cellule s'intègre, et dont elle vient remplacer la bobine RF. Il s'ensuit qu'une cellule de mesure est spécifiquement adaptée à un type particulier de sonde RMN.
- Deuxièmement, le montage de la cellule est long est complexe. Il faut d'abord extraire la sonde RMN de l'aimant de l'appareil de mesure, démonter sa bobine RF, la remplacer par la cellule de mesure, puis réintroduire l'ensemble dans l'appareil. Et ces opérations doivent être répétées à chaque changement d'échantillon.

La publication de A. Tang et A. Jerschow (A. Tang et A. Jerschow, « Practical aspects of liquid-state NMR with inductively coupled solenoid coils », Magnetic Resonance in Chemistry, 48 : 763-770, 2010) présente une micro-bobine RMN entourant un capillaire qui contient un échantillon liquide, l'ensemble capillaire - micro-bobine étant situé dans un tube RMN rempli d'une huile permettant de réduire les effets de susceptibilité magnétique. Le tube est inséré dans une sonde RMN du commerce et la micro-bobine est alimentée par couplage inductif avec la bobine à selle de cheval de la sonde. Cet ensemble présente l'inconvénient d'être à usage unique.

L'invention vise à surmonter ces inconvénients. Plus particulièrement elle vise à procurer une cellule de mesure par résonance magnétique nucléaire en milieu liquide (ou, plus généralement, fluide) qui soit plus simple d'utilisation et moins dépendante du choix d'un type particulier de sonde RMN que la cellule connue de l'art antérieur, tout en préservant ses caractéristiques avantageuses.

Conformément à l'invention, ce but est atteint grâce à une cellule qui :
- d'une part, présente une micro-bobine couplée de manière inductive avec la bobine RF de la sonde, au lieu d'être connectée électriquement à la place de cette dernière ;
- d'autre part, a une forme permettant son introduction dans la sonde de résonance magnétique nucléaire en remplacement - c'est-à-dire à l'emplacement normalement occupé par - d'un ensemble formé par un tube pour résonance magnétique nucléaire et un « rotor » portant ledit tube (le « rotor », ou « spinner » en anglais, est simplement un support pour le tube RMN ; il doit son nom au fait que dans certains appareils de RMN, principalement anciens, il est mis en rotation). Il existe un nombre limité de formes et dimensions pour les tubes RMN et les rotors dans le commerce. Plus précisément, la micro-bobine et la chambre de mesure sont alors placées dans la partie de la cellule correspondant au tube RMN, tandis que le réservoir de liquide et l'injecteur de gaz occupent la partie de la cellule correspondant au rotor.

Le couplage inductif entre la micro-bobine de la cellule de mesure et la bobine RF de la sonde permet de ne pas avoir à démonter cette dernière. En outre, la cellule de mesure ne doit plus comporter une connectique spécifique, ce qui la rend largement indépendante de la sonde de mesure utilisée. La forme de la cellule de mesure permet de l'introduire exactement comme on introduirait un tube de RMN standard, avec son rotor. Bien entendu, cela n'est possible que grâce à l'absence de connexion électrique entre la micro-bobine et la sonde. Par rapport au dispositif précité de A. Tang et A. Jerschow, la cellule de l'invention présente l'avantage d'être réutilisable grâce à la présence du circuit fluidique. Il convient de noter qu'il ne serait pas possible, pour des raisons d'encombrement, d'introduire un circuit fluidique dans un simple tube RMN, ce qui explique pourquoi A. Tang et A. Jerschow utilisent comme chambre de mesure un simple capillaire scellé à une extrémité.

L'invention est définie par les revendications.

Un objet de l'invention est donc une cellule de mesure par résonance magnétique nucléaire en milieu liquide, comprenant :
- un réservoir pour ledit milieu liquide ;
- un circuit fluidique relié audit réservoir et comprenant une chambre de mesure ;
- un injecteur de gaz débouchant dans ledit circuit fluidique, à distance de ladite chambre de mesure ; et
- une bobine entourant ladite chambre de mesure ;

dans la cellule de mesure le circuit fluidique comprend également un orifice de sortie de gaz, espacé dudit injecteur de gaz et présente une forme telle que l'introduction de gaz par ledit injecteur entraîne une mise en circulation du milieu liquide dans le circuit fluidique ;
caractérisée en ce que :
   - elle comprend également au moins un élément capacitif formant, avec ladite bobine, un résonateur électromagnétique ;
et en ce que :
   - elle présente une forme permettant son introduction dans une sonde de résonance magnétique nucléaire en remplacement d'un ensemble formé par un tube pour résonance magnétique nucléaire standard et un rotor portant ledit tube, la bobine entourant la chambre de mesure étant alors positionnée de manière à se coupler par induction avec au moins une bobine à radiofréquence de ladite sonde :
et en ce que - la bobine est placée dans une partie de la cellule destinée à occuper, à l'intérieur de la sonde, un emplacement prévu pour le tube pour résonance magnétique nucléaire, tandis que le réservoir et l'injecteur de gaz sont placés dans une autre partie de la cellule destinée à occuper, à l'intérieur de la sonde, un emplacement prévu pour le rotor.

Selon des modes de réalisation particuliers d'une telle cellule de mesure :
- La cellule peut comprendre également au moins un injecteur de fluide, autre que ledit injecteur de gaz, débouchant dans ledit conduit fluidique.
- La cellule peut comprendre également un système mécanique permettant de faire tourner la cellule de mesure, à l'intérieur de ladite sonde de résonance magnétique nucléaire, autour d'un axe perpendiculaire à un axe longitudinal de ladite bobine.
- La cellule peut être fabriquée, à l'exception tout au plus de ladite chambre de mesure et dudit résonateur électromagnétique, par impression tridimensionnelle. Plus particulièrement, ledit réservoir peut avoir des parois internes présentant un revêtement protecteur, par exemple en parylène.

Un autre objet de l'invention est un système de mesure par résonance magnétique nucléaire comprenant :
- un spectromètre par résonance magnétique nucléaire;
- une sonde de résonance magnétique nucléaire, montée à l'intérieur dudit spectromètre par résonance magnétique nucléaire ; et
- une cellule de mesure telle qu'exposée ci-dessus, agencée à l'intérieur de ladite sonde de résonance magnétique nucléaire en remplacement d'un ensemble formé par un tube pour résonance magnétique nucléaire et un rotor portant ledit tube.

Dans un tel système de mesure, la bobine de ladite cellule de mesure peut avantageusement être orientée de manière à maximiser le couplage par induction avec une bobine à radiofréquence de ladite sonde.

Encore un autre objet de l'invention est un procédé de mesure par résonance magnétique comprenant les étapes consistant à :
a) remplir le réservoir et le circuit fluidique d'une cellule de mesure telle qu'exposée ci-dessus avec un milieu liquide, objet de la mesure ;
b) introduire ladite cellule de mesure dans une sonde de résonance magnétique nucléaire montée dans un spectromètre par résonance magnétique nucléaire, à l'emplacement prévu pour un ensemble formé par un tube pour résonance magnétique nucléaire standard et un rotor portant ledit tube, de manière à ce qu'une bobine à radiofréquence de ladite sonde et ladite bobine entourant la chambre de mesure soient couplées inductivement ;
c) introduire un gaz dans l'injecteur de gaz de ladite cellule de mesure, entrainant une mise en circulation du milieu liquide dans le circuit fluidique de la cellule ;
d) appliquer à une bobine à radiofréquence de ladite sonde, couplée par induction à la bobine de ladite cellule de mesure, un signal à radiofréquence à une fréquence de résonance du résonateur électromagnétique de ladite cellule de mesure ; et
e) utiliser ladite ou une autre bobine à radiofréquence de ladite sonde, également couplée par induction à la bobine de ladite cellule de mesure, pour acquérir un signal de résonance magnétique nucléaire.

Un tel procédé peut avantageusement comprendre une étape additionnelle consistant à :
f) faire tourner la cellule de mesure autour d'un axe perpendiculaire à un axe longitudinal de sa bobine jusqu'à maximiser une intensité dudit signal de résonance magnétique nucléaire.

Le gaz introduit dans l'injecteur de gaz de ladite cellule de mesure peut être un gaz hyperpolarisé.

Le procédé peut comprendre également, après ladite étape c), une étape consistant à :
c1) introduire dans la cellule de mesure, au moyen dudit injecteur de gaz ou dudit ou d'au moins un dit injecteur de fluide, au moins un fluide apte à engendrer une réaction chimique ou biochimique avec le liquide contenu dans le réservoir et le circuit fluidique de ladite cellule de mesure, le signal de résonance magnétique nucléaire acquis lors de ladite étape e) permettant de suivre le déroulement de ladite réaction chimique ou biochimique.

D'autres caractéristiques, détails et avantages de l'invention ressortiront à la lecture de la description faite en référence aux dessins annexés donnés à titre d'exemple et qui représentent, respectivement :
- La figure 1, un schéma de principe d'une cellule de mesure selon l'invention ;
- Les figures 2A et 2B, une vue en coupe d'une cellule de mesure selon un mode de réalisation de l'invention ;
- La figure 3A, une vue en perspective de la cellule des figures 2A et 2B, et la figure 3B un détail de la figure 3A ;
- Les figures 4A et 4B, respectivement, un schéma et un graphique de données expérimentales illustrant une opération d'optimisation du couplage inductif entre la bobine RF de la sonde et celle de la cellule de mesure ;
- La figure 5, une vue en coupe d'un système de mesure par RMN incluant une cellule de mesure selon l'invention ; et
- La figure 6, les puissances réfléchies d'une sonde de l'art antérieur et d'une sonde selon l'invention.

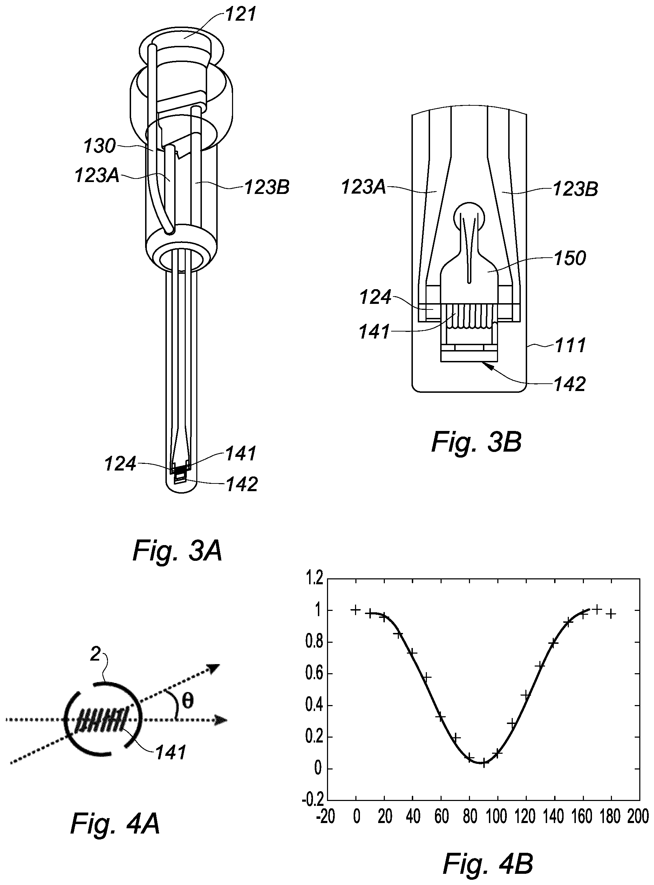

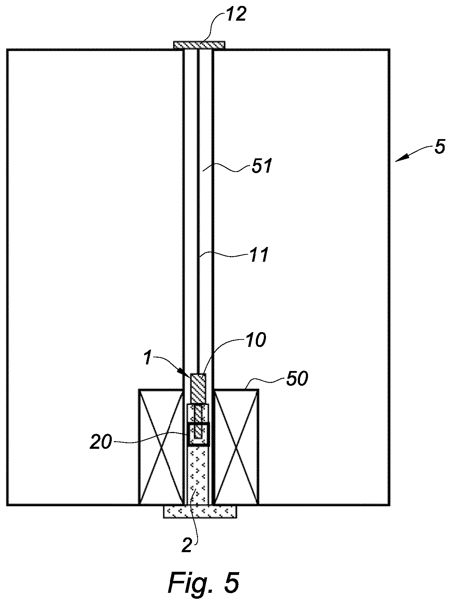

Une cellule de mesure 1 comprend un insert 10, destiné à être introduit dans une sonde de RMN à la place d'un ensemble rotor - tube, ainsi qu'une tige en matériau amagnétique 11 se terminant par un ergot 12. La tige 11 permet d'introduire l'insert dans un espace cylindrique entouré par l'aimant du système de mesure par RMN, à l'extrémité duquel se trouve la sonde RMN (voir la figure 5, où l'aimant est désigné par la référence 50, l'espace cylindrique par 51 et la sonde RMN par 2). L'insertion se fait typiquement par le haut, jusqu'à ce que l'ergot 12 vienne en butée contre la surface supérieure du système. La longueur de la tige 11 est choisie de telle sorte que, à ce point, l'insert 10 soit positionné au milieu de la bobine RF 20 de la sonde 2. De préférence, l'insert peut tourner à l'intérieur de l'espace 51, autour d'un axe matérialisé par la tige ; avantageusement, l'ergot 12 est gradué, de telle sorte que l'orientation de l'insert puisse être connue et donc ajustée précisément. L'importance de ces caractéristiques sera comprise plus loin en référence aux figures 3A et 3B.

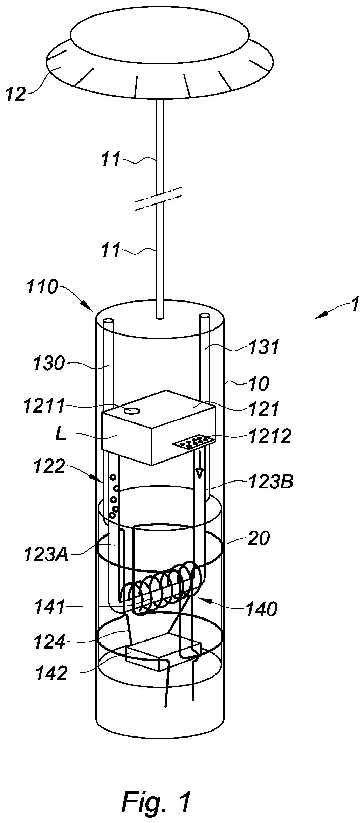

Selon un mode de réalisation avantageux de l'invention, l'insert 10 est essentiellement constitué d'un bloc de matériau polymère 110, ou « corps » de la cellule, fabriqué de manière additive (impression 3D). Un volume vide 120 à l'intérieur de ce bloc définit un réservoir 121, situé dans la partie supérieure de l'insert, ainsi qu'un circuit fluidique 122 ayant deux extrémités débouchant dans le réservoir. Dans le mode de réalisation de la figure 1, le circuit fluidique 122 présente une forme généralement en « U » et comprend deux bras d'orientation verticale, 123A et 123B, et une portion horizontale 124, constituant la chambre de mesure. Un conduit 130, également d'orientation verticale, présente une extrémité débouchant dans le bras 123A et une autre extrémité en communication avec l'extérieur de l'insert, de manière à permettre l'insertion de gaz dans le circuit fluidique 122. Le gaz injecté forme des bulles 1000 qui remontent vers le réservoir, induisant une circulation du liquide L remplissant le circuit fluidique dans le sens du déplacement des bulles. En haut du réservoir, une ouverture 1211 permet au gaz de s'échapper. Une grille 1212, à l'entrée du bras 123B du circuit, empêche que de la mousse, éventuellement formée par l'injection de gaz, puisse être entrainée jusqu'à la chambre de mesure.

La cellule de la figure 1 comprend également un conduit d'injection de fluides additionnel 131, débouchant dans le bras 123B. Ce conduit peut servir, par exemple, à introduire un réactif dans la cellule. La présence d'un ou plusieurs de ces conduits additionnels est optionnelle. Lorsqu'ils sont présents, leur nombre est typiquement compris entre 1 et 4.

Une bobine 141 de type solénoïde entoure la chambre de mesure 124 et forme, avec un élément capacitif (condensateur) 142, un résonateur électromagnétique, et plus précisément un circuit résonant 140 de type LC, accordé à la fréquence de fonctionnement de la sonde RMN 2. On remarque que la bobine 141 se trouve au milieu de la bobine RF 20 de la sonde 2, qui peut être du type « à selle de cheval ». Les deux bobines sont couplées de manière inductive ; autrement dit, elles forment le primaire et le secondaire d'un transformateur. Ainsi, lorsque la bobine 20 est alimentée par un signal à radiofréquence à une fréquence f à l'intérieur de la bande de résonance du circuit LC 140, ce dernier est excité à son tour. La bobine 141 de la cellule transfère ce signal aux spins nucléaires contenus dans la chambre de mesure, et recueille leur signal de réponse. Ce signal de réponse est transmis, également par couplage inductif, à la bobine 20, d'où elle parvient à la chaîne d'acquisition du système de RMN. La chambre de mesure est très petite par rapport au volume intérieur de la bobine 20, par conséquent cette dernière ne pourrait ni exciter efficacement les spins nucléaires, ni recueillir efficacement le signal RMN, cela à cause du faible facteur de remplissage. Au contraire, la bobine 141 présente un facteur de remplissage élevé, et peut donc exciter efficacement les spins nucléaires à l'intérieur de la chambre de mesure, et recueillir tout aussi efficacement le signal d'intérêt.

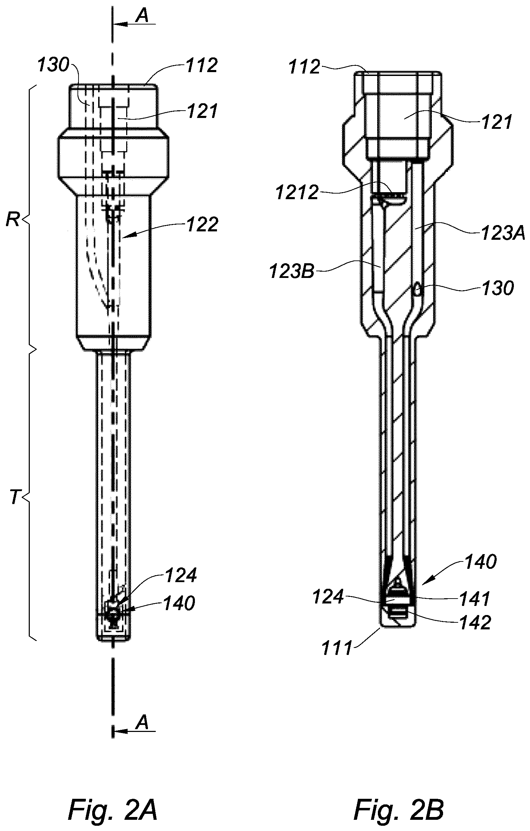

La figure 1 est très schématique, et ne reproduit pas la véritable forme d'une cellule de mesure selon l'invention. Cette forme, par contre, est représentée sur les figures 2A et 2B (vues en coupe ; la figure 2B correspond en particulier à une coupe selon la direction A - A identifiée sur la figure 2A), ainsi que sur la figure 3A (vue en perspective). Sur ces figures on peut distinguer une partie supérieure R dont la forme et les dimensions correspondent à celles d'un « rotor », et une partie inférieure T, plus étroite et allongée, dont la forme et les dimensions correspondent à celles d'un tube de RMN. La partie supérieure R comprend le circuit fluidique et la partie inférieure T comprend la chambre de mesure et la micro-bobine.

La figure 3B montre une vue de détail de l'extrémité inférieure du corps de la cellule de mesure, contenant la chambre de mesure 124 et le circuit résonant 140. La référence 150 désigne un conduit débouchant vers l'extérieur qui permet d'évacuer l'air entourant la bobine afin d'améliorer l'homogénéité du champ magnétique et du champ radiofréquence.

Les dimensions des différents éléments de la cellule peuvent varier dans certaines limites tout en gardant une compatibilité avec la plupart des sondes RMN du commerce. Par exemple :
- L'injecteur de gaz 130 peut présenter un diamètre typiquement compris entre 50 µm et 800 µm ; il en va de même pour d'éventuels autres conduits 131 d'injection de fluide.
- Les conduits constituant le circuit fluidique 122 peuvent présenter des diamètres internes typiquement compris entre 0,5 et 3 mm.
- La grille 1212 peut présenter des ouvertures de diamètre typiquement compris entre 0,5 et 1 mm.
- Le réservoir 121 peut présenter un volume typiquement compris entre 50 et 500 µL.
- La partie inférieure T du corps de la sonde peut présenter une longueur qui est typiquement de l'ordre de 60 mm et un diamètre typiquement compris entre 5 mm et 20 mm.
- La chambre de mesure 124 peut être constituée d'un capillaire présentant un diamètre interne typiquement compris entre 0,8 et 2 mm.
- La bobine 141 peut présenter un diamètre intérieur typiquement compris entre 1 et 2,5 mm (en tout cas, supérieur ou égal au diamètre externe de la chambre de mesure) et une longueur typiquement compris entre 2 et 15 mm.

La chambre de mesure est de préférence réalisée en matériau cristallin, afin de présenter une bonne homogénéité, et amagnétique ; il peut avantageusement s'agir du quartz. Tous les autres éléments de la cellule, mis à part le circuit résonant 140, peuvent être réalisés en matériau polymère et fabriqués par impression 3D, notamment par photopolymérisation. Typiquement, le corps de la cellule est fabriquée en trois parties : une partie principale, comprenant tout le circuit fluidique à l'exception du capillaire constituant la chambre de mesure, un capuchon (référence 111 sur les figures 2B et 3B) fermant l'extrémité inférieure de la cellule et un bouchon (référence 112 sur les figures 2A et 2B) pour fermer le réservoir, à l'extrémité supérieure du corps de la cellule. L'ensemble constitué par la chambre de mesure et le circuit résonant est assemblé avec la partie principale du corps de la sonde, puis le capuchon 111 est collé de manière à sceller l'assemblage. Le bouchon 112, relié à la tige 11, est appliqué pour fermer le réservoir.

En variante, tout le corps de la cellule, excepté tout au plus le bouchon, peut être fabriqué d'un seul tenant, autour de l'assemblage pré-positionné formé par la chambre de mesure et le circuit résonant.

La fabrication par impression 3D présente l'avantage d'être très simple par rapport à d'autres méthodes envisageables comme l'assemblage à partir d'éléments fabriqués séparément par moulage ou soufflage de verre. Toutefois, il présente également un inconvénient significatif : en effet, les résines d'impression 3D sont généralement polymérisées de manière incomplète et, de ce fait, facilement attaquées par des solvants. En outre, elles sont cytotoxiques, ce qui est rédhibitoire pour certaines applications (RMN de cellules vivantes, par exemple). Pour pallier cet inconvénient, il est possible de déposer une couche protectrice sur les surfaces internes du circuit fluidique. Il peut s'agir en particulier d'une couche en parylène réalisée par dépôt chimique en phase vapeur (CVD, de l'anglais « Chemical Vapor Deposition ») et présentant typiquement une épaisseur comprise entre 500 nm et 1 µm, par exemple d'environ 700 nm.

L'utilisation d'une cellule de mesure selon l'invention est simple. Tout d'abord, comme illustré schématiquement sur la figure 5, une sonde RMN conventionnelle est installée dans l'aimant 50 d'un spectromètre RMN 5 par l'extrémité inférieure de ce dernier. La cellule de mesure 1 est remplie du liquide L a étudier, puis elle est fermée au moyen du capuchon supérieur 112 prolongé par la tige 11. Un tube flexible - non représenté sur la figure 5 - est relié d'une part à une pompe à gaz et d'autre part à l'entrée du conduit d'injection 130 (d'autres conduits d'injection 131 peuvent être reliés à des pompes respectives). L'ensemble ainsi obtenu est introduit, par l'extrémité supérieure du spectromètre 5, dans le volume 51 situé à l'intérieur de l'aimant, jusqu'à ce que l'ergot 12 vienne se plaquer sur la surface supérieure du spectromètre 5. A ce point, la chambre de mesure de la sonde se trouve au centre de la bobine 20 de la sonde 2. Le couplage inductif entre les bobines 20 et 141 dépend de l'orientation de l'axe longitudinal de cette dernière par rapport à la première. Or, cette orientation peut être modifiée en faisant tourner l'ergot 12. La figure 4A est une vue du haut de la bobine 20, du type « à selle de cheval », et de la bobine 141, de type solénoïdal, agencée à son intérieur. La normale à la bobine 20 forme un angle θ avec l'axe longitudinal de la bobine 141. La figure 4B montre la dépendance de l'intensité du signal RMN de l'angle θ. On peut vérifier que le signal s'annule pour θ=90° et prend une valeur maximale pour θ=0° ou 180°. On comprend donc l'importance de procéder à la maximisation du couplage inductif par ajustement de l'angle θ avant le début de la mesure.

La mesure RMN - typiquement, de spectroscopie et/ou de micro-imagerie, est ensuite effectuée de manière tout à fait conventionnelle. Il faudra juste considérer que la présence de la bobine 141 modifie (diminue) la fréquence de résonance de la sonde 2. Comme la sonde est généralement accordable, dans une certaine mesure, cet effet peut être compensé. En variante, il peut être exploité pour détecter d'autres espèces nucléaires que celles pour lesquelles la sonde a été conçue.

L'invention a été décrite en référence à un mode de réalisation particulier, mais de nombreuses variantes, entrant dans le champ de protection des revendications, peuvent être envisagées. Par exemple :
- Le bouchon 112 peut ne pas être présent, auquel cas le remplissage de la cellule se fait par un conduit 130 ou 131.
- La sonde 2 peut comprendre plusieurs bobines distinctes fonctionnant en émission et/ou réception, toutes couplées avec la bobine - voire des bobines - de la cellule de mesure (cas d'un appareil RMN multi-canaux rf), cela permet notamment de réaliser des expériences multi-noyaux.
- Le couplage inductif permet de positionner une ou plusieurs bobines radiofréquences dans la zone d'action de la bobine RF de la sonde 20 en des positions le long d'un circuit de la solution, permettant ainsi de focaliser localement le champ radiofréquence et ainsi augmenter, en des positions choisies, la sensibilité de la sonde. Cela peut être particulièrement utile pour suivre une succession de réactions subies par un système chimique ou pour réaliser un suivi de processus et une cartographie des espèces formées le long du ou des circuits.
- Le résonateur électromagnétique 140 peut être plus complexe qu'un simple circuit LC. Par exemple il peut être accordable, typiquement grâce à l'utilisation d'un élément capacitif variable. Il peut également s'agir d'un circuit à plusieurs fréquences de résonance : de cette manière, une seule et même cellule de mesure peut être utilisée pour détecter plusieurs espèces nucléaires distinctes.
- La bobine 141 peut être entourée d'un volume rempli d'un solvant dont la susceptibilité correspond à celle du liquide L objet de la mesure, ce qui permet d'augmenter l'homogénéité du champ magnétique perçu et ainsi améliorer le signal reçu.
- Le système tige 11 - ergot 12 peut être remplacé par n'importe quel autre système mécanique de maintien, de préférence permettant un réglage de l'angle d'orientation θ ou assurant une orientation fixe et prédéterminée.

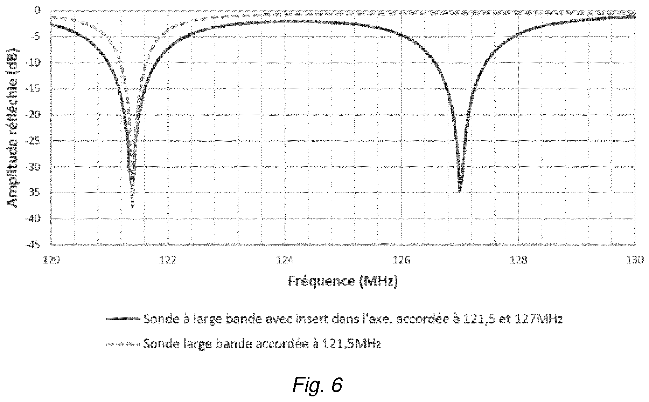

La figure 6 présente les puissances réfléchies, mesurées par un analyseur de réseau, en fonction de la fréquence d'une sonde RMN de l'art antérieur ne comprenant pas de système inductif et d'une sonde RMN selon un mode de réalisation de l'invention. L'insertion d'un système inductif permet de faire apparaître une deuxième fréquence de résonance. En effet, la sonde selon l'invention présente deux résonateurs accordés à des fréquences proches et couplés inductivement : résonateur formé par la micro-bobine et le condensateur et résonateur formé par la bobine et les condensateurs d'accord de la sonde. A cause du couplage inductif, on a deux fréquences de résonance dont l'espacement dépend de la force du couplage, et donc de l'angle entre la micro-bobine et la bobine de la sonde. C'est pourquoi, on observe une première fréquence de résonance à 121,5 MHz et une seconde fréquence de résonance à 127 MHz pour la sonde selon l'invention.

En utilisant les graduations de l'ergot pour connaître l'angle formé par la micro-bobine et la bobine de la sonde et en choisissant les valeurs d'inductance et de capacité de la micro-bobine et du condensateur formant le résonateur de l'insert, il est alors possible d'utiliser ces deux fréquences de résonance pour étudier deux noyaux résonnant à des fréquences différentes tout en profitant du gain de sensibilité permis par le circuit fluidique et la micro-bobine.

## Revendications

1. Cellule de mesure (1) par résonance magnétique nucléaire en milieu liquide, comprenant :
- un réservoir (121) pour ledit milieu liquide ;
- un circuit fluidique (122) relié audit réservoir et comprenant une chambre de mesure (124) ;
- un injecteur de gaz (130) débouchant dans ledit circuit fluidique, à distance de ladite chambre de mesure ; et
- une bobine (141) entourant ladite chambre de mesure ;
dans la cellule de mesure le circuit fluidique comprend également un orifice de sortie de gaz (1211), espacé dudit injecteur de gaz et présente une forme telle que l'introduction de gaz par ledit injecteur entraîne une mise en circulation du milieu liquide dans le circuit fluidique ; **caractérisée en ce que** :
- elle comprend également au moins un élément capacitif (142) formant, avec ladite bobine, un résonateur électromagnétique (140) ;
**en ce que** :
- elle présente une forme permettant son introduction dans une sonde (2) de résonance magnétique nucléaire en remplacement d'un ensemble formé par un tube pour résonance magnétique nucléaire standard et un rotor portant ledit tube, la bobine (141) entourant la chambre de mesure étant alors positionnée de manière à se coupler par induction avec au moins une bobine à radiofréquence (20) de ladite sonde ;
Et **en ce que**
- la bobine (141) est placée dans une partie (T) de la cellule destinée à occuper, à l'intérieur de la sonde, un emplacement prévu pour le tube pour résonance magnétique nucléaire, tandis que le réservoir (121) et l'injecteur de gaz (130) sont placés dans une autre partie (R) de la cellule destinée à occuper, à l'intérieur de la sonde, un emplacement prévu pour le rotor.

2. Cellule de mesure selon l'une des revendications précédentes, comprenant également au moins un injecteur de fluide (131), autre que ledit injecteur de gaz, débouchant dans ledit conduit fluidique.

3. Cellule de mesure selon l'une des revendications précédentes, comprenant également un système mécanique (11, 12) permettant de faire tourner la cellule de mesure, à l'intérieur de ladite sonde de résonance magnétique nucléaire, autour d'un axe perpendiculaire à un axe longitudinale de ladite bobine.

4. Cellule de mesure selon l'une des revendications précédentes fabriquée, à l'exception tout au plus de ladite chambre de mesure et dudit résonateur électromagnétique, par impression tridimensionnelle.

5. Cellule de mesure selon la revendication 4 dans laquelle ledit réservoir et ledit circuit fluidique sont réalisés en résine photopolymérisée et ont des parois internes présentant un revêtement protecteur.

6. Cellule de mesure selon la revendication 5 dans laquelle ledit revêtement protecteur est en parylène.

7. Système de mesure par résonance magnétique nucléaire comprenant :
- un spectromètre (5) par résonance magnétique nucléaire;
- une sonde (2) de résonance magnétique nucléaire, montée à l'intérieur dudit spectromètre par résonance magnétique nucléaire ; et
- une cellule de mesure (1) selon l'une des revendications précédentes, agencée à l'intérieur de ladite sonde de résonance magnétique nucléaire en remplacement d'un ensemble formé par un tube pour résonance magnétique nucléaire et un rotor portant ledit tube.

8. Système de mesure selon la revendication 7 dans lequel la bobine (141) de ladite cellule de mesure est orientée de manière à maximiser le couplage par induction avec une bobine à radiofréquence de ladite sonde.

9. Procédé de mesure par résonance magnétique comprenant les étapes consistant à :
a) remplir le réservoir (121) et le circuit fluidique (122) d'une cellule de mesure selon l'une des revendications 1 à 6 avec un milieu liquide (L), objet de la mesure ;
b) introduire ladite cellule de mesure dans une sonde (2) de résonance magnétique nucléaire montée dans un spectromètre (5) par résonance magnétique nucléaire, à l'emplacement prévu pour un ensemble formé par un tube pour résonance magnétique nucléaire et un rotor portant ledit tube, de manière à ce qu'une bobine à radiofréquence (20) de ladite sonde (2) et ladite bobine (141) entourant la chambre de mesure soient couplées inductivement ;
c) introduire un gaz dans l'injecteur de gaz de ladite cellule de mesure, entrainant une mise en circulation du milieu liquide dans le circuit fluidique de la cellule ;
d) appliquer à une bobine à radiofréquence (20) de ladite sonde (2), couplée par induction à la bobine de ladite cellule de mesure, un signal à radiofréquence à une fréquence de résonance du résonateur électromagnétique de ladite cellule de mesure ; et
e) utiliser ladite ou une autre bobine à radiofréquence de ladite sonde, également couplée par induction à la bobine de ladite cellule de mesure, pour acquérir un signal de résonance magnétique nucléaire.

10. Procédé de mesure selon la revendication 9 comprenant également une étape consistant à :
f) faire tourner la cellule de mesure autour d'un axe perpendiculaire à un axe longitudinal de sa bobine jusqu'à maximiser une intensité dudit signal de résonance magnétique nucléaire.

11. Procédé de mesure selon l'une des revendications 9 ou 10 dans lequel le gaz introduit dans l'injecteur de gaz (130) de ladite cellule de mesure est un gaz hyperpolarisé.

12. Procédé de mesure selon l'une des revendications 9 à 11, comprenant également, après ladite étape c), une étape consistant à :
c1) introduire dans la cellule de mesure, au moyen dudit injecteur de gaz ou dudit ou d'au moins un dit injecteur de fluide, au moins un fluide adapté à engendrer une réaction chimique ou biochimique avec le liquide contenu dans le réservoir et le circuit fluidique de ladite cellule de mesure ;
le signal de résonance magnétique nucléaire acquis lors de ladite étape e) permettant de suivre le déroulement de ladite réaction chimique ou biochimique.

13. Procédé de mesure selon l'une des revendications 9 à 12, comprenant également après ladite étape b) et avant ladite étape d), une étape consistant à :
c1) orienter ladite bobine (141) entourant la chambre de mesure de manière à ce que l'ensemble formé par ladite bobine à radiofréquence (20), ladite bobine (141) entourant la chambre de mesure et ledit élément capacitif présente deux fréquences de résonance correspondant aux fréquences de résonance de deux noyaux différents à l'intensité du champ magnétique dans la sonde (2) de résonance magnétique nucléaire ;
et comprenant également après ladite étape d) une étape consistant à :
e1) utiliser ladite bobine à radiofréquence (20) de ladite sonde, couplée par induction à ladite bobine (141) entourant la chambre de mesure, pour acquérir un signal de résonance magnétique nucléaire des deux dits noyaux.

## Patentansprüche

1. Kernspinresonanz-Messzelle (1) in einem flüssigen Medium, umfassend:
- einen Behälter (121) für das flüssige Medium;
- einen Fluidkreislauf (122), der mit dem Behälter verbunden ist und eine Messkammer (124) umfasst,
- einen Gasinjektor (130), der in einem Abstand zur Messkammer in dem Fluidkreislauf mündet; und
- eine Spule (141), die die Messkammer umgibt;
in der Messzelle umfasst der Fluidkreislauf außerdem eine Gasaustrittsöffnung (1211), die vom Gasinjektor beabstandet ist und eine solche Form aufweist, dass das Einbringen von Gas durch den Injektor ein Strömen des flüssigen Mediums in dem Fluidkreislauf bewirkt; **dadurch gekennzeichnet, dass**:
- sie außerdem mindestens ein kapazitives Element (142) umfasst, welches mit der Spule einen elektromagnetischen Resonator (140) bildet;
dadurch, dass:
- sie eine Form aufweist, die es ermöglicht, sie in eine Kernspinresonanzsonde (2) einzuführen, als Ersatz für eine Gruppe, die aus einer Standardkernspinresonanzröhre und einem die Röhre tragenden Rotor gebildet ist, wobei die Spule (141) die Messkammer umgibt, die dann so positioniert ist, dass sie sich durch Induktion mit mindestens einer Hochfrequenzspule (20) der Sonde koppelt;
und dadurch, dass
- die Spule (141) in einem Teil (T) der Zelle platziert ist, der im Inneren der Sonde einen Platz belegen soll, der für die Röhre für die Kernspinresonanz bereitgestellt ist, während der Behälter (121) und der Gasinjektor (130) in einem anderen Teil (R) der Zelle platziert sind, der im Inneren der Sonde einen Platz belegen soll, der für den Rotor bereitgestellt ist.

2. Messzelle nach einem der vorhergehenden Ansprüche, umfassend außerdem mindestens einen Fluidinjektor (131) außer dem Gasinjektor, der in dem Fluidkanal mündet.

3. Messzelle nach einem der vorhergehenden Ansprüche, umfassend außerdem ein mechanisches System (11, 12), dass es ermöglicht, die Messzelle im Inneren der Kernspinresonanzsonde um eine Achse zu drehen, die senkrecht zu einer Längsachse der Spule ist.

4. Messzelle nach einem der vorhergehenden Ansprüche, die, mit Ausnahme höchstens der Messkammer und des elektromagnetischen Resonators, durch dreidimensionalen Druck gefertigt ist.

5. Messzelle nach Anspruch 4, wobei der Behälter und der Fluidkreislauf aus fotopolymerisiertem Harz hergestellt sind und Innenwände aufweisen, die eine Schutzbeschichtung aufweisen.

6. Messzelle nach Anspruch 5, wobei die Schutzbeschichtung Parylen ist.

7. Kernspinresonanzmesssystem, umfassend:
- ein Kernspinresonanzspektrometer (5);
- eine Kernspinresonanzsonde (2), die im Inneren des Kernspinresonanzspektrometers montiert ist; und
- eine Messzelle (1) nach einem der vorhergehenden Ansprüche, die im Inneren der Kernspinresonanzsonde als Ersatz für eine Gruppe angeordnet ist, die durch eine Röhre für Kernspinresonanz und einen die Röhre tragenden Rotor gebildet ist.

8. Messsystem nach Anspruch 7, wobei die Spule (141) der Messzelle so ausgerichtet ist, dass die Kopplung durch Induktion mit einer Hochfrequenzspule der Sonde maximiert wird.

9. Magnetresonanzmessverfahren, umfassend die folgenden Schritte:
a) Füllen des Behälters (121) und des Fluidkreislaufs (122) einer Messzelle nach einem der Ansprüche 1 bis 6 mit einem flüssigen Medium (L), das Gegenstand der Messung ist;
b) Einführen der Messzelle in eine Kernspinresonanzsonde (2), die in einem Kernspinresonanzspektrometer (5) montiert ist, an der Stelle, die für eine Gruppe bereitgestellt ist, die durch eine Röhre für Kernspinresonanz und einen die Röhre tragenden Rotor gebildet ist, sodass eine Hochfrequenzspule (20) der Sonde (2) und die die Messkammer umgebende Spule (141) induktiv gekoppelt werden;
c) Einbringen eines Gases in den Gasinjektor der Messzelle, was ein Strömen des flüssigen Mediums in dem Fluidkreislauf der Zelle bewirkt;
d) Anlegen, an eine Hochfrequenzspule (20) der Sonde (2), die durch Induktion mit der Spule der Messzelle gekoppelt ist, eines Hochfrequenzsignals mit einer Resonanzfrequenz des elektromagnetischen Resonators der Messzelle; und
e) Verwenden der oder einer anderen Hochfrequenzspule der Sonde, die ebenfalls durch Induktion mit der Spule der Messzelle gekoppelt ist, um ein Kernspinresonanzsignal zu erfassen.

10. Messverfahren nach Anspruch 9, außerdem umfassend einen Schritt des:
f) Drehens der Messzelle um eine Achse senkrecht zu einer Längsachse ihrer Spule, bis eine Intensität des Kernspinresonanzsignals maximiert wird.

11. Messverfahren nach einem der Ansprüche 9 oder 10, wobei das in den Gasinjektor (130) der Messzelle eingebrachte Gas ein hyperpolarisiertes Gas ist.

12. Messverfahren nach einem der Ansprüche 9 bis 11, außerdem umfassend, nach Schritt c), einen Schritt des:
c1) Einbringens, in die Messzelle mittels des Gasinjektors oder des oder mindestens eines Fluidinjektors, mindestens eines Fluids, das dafür geeignet ist, eine chemische oder biochemische Reaktion mit der in dem Behälter enthaltenen Flüssigkeit und dem Fluidkreislauf der Messzelle hervorzurufen;
wobei es das im Schritt e) erfasste Kernspinresonanzsignal ermöglicht, den Ablauf der chemischen oder biochemischen Reaktion zu verfolgen.

13. Messverfahren nach einem der Ansprüche 9 bis 12, außerdem umfassend, nach Schritt b) und vor Schritt d), einen Schritt des:
c1) Ausrichtens der Spule (141), die die Messkammer umgibt, derart, dass die aus der Hochfrequenzspule (20), der die Messkammer umgebenden Spule (141) und dem kapazitiven Element gebildete Gruppe zwei Resonanzfrequenzen aufweist, die den Resonanzfrequenzen von zwei verschiedenen Kernen mit der Intensität des Magnetfelds in der Kernspinresonanzsonde (2) entspricht;
und außerdem umfassend, nach dem Schritt d), einen Schritt des:
e1) Verwendens der Hochfrequenzspule (20) der Sonde, die durch Induktion mit der die Messkammer umgebenden Spule (141) gekoppelt ist, um ein Kernspinresonanzsignal der zwei Kerne zu erfassen.

## Claims

1. A nuclear-magnetic-resonance measurement cell (1) in a liquid medium, comprising:
- a reservoir (121) for said liquid medium;
- a fluidic circuit (122) connected to said reservoir and comprising a measurement chamber (124);
- a gas injector (130) opening into said fluidic circuit, at a distance from said measurement chamber; and
- a coil (141) encircling said measurement chamber;
in the measurement cell, the fluidic circuit also comprises a gas outlet port (1211), spaced apart from said gas injector and having a shape such that the introduction of gas by said injector causes the liquid medium to flow through the fluidic circuit; **characterised in that**:
- it also comprises at least one capacitive element (142) forming, with said coil, an electromagnetic resonator (140);
**in that**:
- it has a shape allowing its introduction into a nuclear-magnetic-resonance probe (2) as a replacement for an assembly formed by a standard nuclear-magnetic-resonance tube and a rotor bearing said tube, the coil (141) encircling the measurement chamber then being positioned so as to couple by induction to at least one radiofrequency coil (20) of said probe;
and **in that**
- the coil (141) is placed in a portion (T) of the cell intended to occupy, inside the probe, a location provided for the nuclear-magnetic-resonance tube, whereas the reservoir (121) and the gas injector (130) are placed in another portion (R) of the cell intended to occupy, inside the probe, a location provided for the rotor.

2. The measurement cell according to one of the preceding claims, also comprising at least one fluid injector (131), other than said gas injector, opening into said fluidic duct.

3. The measurement cell according to one of the preceding claims, also comprising a mechanical system (11, 12) allowing the measurement cell to rotate inside said nuclear-magnetic-resonance probe, about an axis perpendicular to a longitudinal axis of said coil.

4. The measurement cell according to one of the preceding claims manufactured, with the exception, at the very most, of said measurement chamber and of said electromagnetic resonator, by three-dimensional printing.

5. The measurement cell according to claim 4, wherein said reservoir and said fluidic circuit are made of photopolymerised resin and have internal walls having a protective coating.

6. The measurement cell according to claim 5, wherein said protective coating is made of parylene.

7. A nuclear-magnetic-resonance measurement system comprising:
- a nuclear-magnetic-resonance spectrometer (5);
- a nuclear-magnetic-resonance probe (2) mounted inside said nuclear-magnetic-resonance spectrometer; and
- a measurement cell (1) according to one of the preceding claims, arranged inside said nuclear-magnetic-resonance probe as a replacement for an assembly formed by a tube for nuclear magnetic resonance and a rotor bearing said tube.

8. The measurement system according to claim 7, wherein the coil (141) of said measurement cell is oriented so as to maximise coupling by induction with a radiofrequency coil of said probe.

9. A magnetic-resonance measurement method comprising the steps of:
a) filling the reservoir (121) and the fluidic circuit (122) of a measurement cell according to one of claims 1 to 6 with a liquid medium (L), subject of the measurement;
b) introducing said measurement cell into a nuclear-magnetic-resonance probe (2) mounted in a nuclear-magnetic-resonance spectrometer (5) at the location provided for an assembly formed by a tube for nuclear magnetic resonance and a rotor bearing said tube, so that a radiofrequency coil (20) of said probe (2) and said coil (141) encircling the measurement chamber are inductively coupled;
c) introducing a gas into the gas injector of said measurement cell, causing the liquid medium to flow through the fluidic circuit of the cell;
d) applying to a radiofrequency coil (20) of said probe (2), coupled by induction to the coil of said measurement cell, a radiofrequency signal at a resonant frequency of the electromagnetic resonator of said measurement cell; and
e) using said or another radiofrequency coil of said probe, also coupled by induction to the coil of said measurement cell, to acquire a nuclear-magnetic-resonance signal.

10. The measurement method according to claim 9, also comprising a step of:
f) rotating the measurement cell about an axis perpendicular to a longitudinal axis of its coil until an intensity of said nuclear-magnetic-resonance signal is maximised.

11. The measurement method according to one of claims 9 or 10, wherein the gas introduced into the gas injector (130) of said measurement cell is a hyperpolarised gas.

12. The measurement method according to one of claims 9 to 11, also comprising, after said step c), a step of:
c1) introducing into the measurement cell, by means of said gas injector or of said or at least one said fluid injector, at least one fluid suitable for generating a biochemical or chemical reaction with the liquid contained in the reservoir and the fluidic circuit of said measurement cell;
the nuclear-magnetic-resonance signal acquired in said step e) enabling the progress of said biochemical or chemical reaction to be monitored.

13. The measurement method according to one of claims 9 to 12, also comprising, after said step b) and before said step d), a step of:
c1) orienting said coil (141) encircling the measurement chamber so that the assembly formed by said radiofrequency coil (20), said coil (141) encircling the measurement chamber and said capacitive element has two resonant frequencies corresponding to the resonant frequencies of two different nuclei at the intensity of the magnetic field in the nuclear-magnetic-resonance probe (2);
and also comprising, after said step d), a step of:
e1) using said radiofrequency coil (20) of said probe, coupled by induction to said coil (141) encircling the measurement chamber, to acquire a nuclear-magnetic-resonance signal of the two said nuclei.
